# EUROPEAN PATENT SPECIFICATION

(11) **EP 2 482 310 B1**
(45) Date of publication and mention of the grant of the patent: **23.09.2020**
(21) Application number: 11000639.2
(22) Date of filing: 27.01.2011
(51) Int. Cl.: H01L 21/768, H01L 23/31

(54) **Through vias in a sensor chip**
Durchkontaktierungen in einem Sensorchip
Trous de connexion dans une puce de capteur

(43) Date of publication of application: 01.08.2012
(73) Proprietor: Sensirion AG, 8712 Stäfa (CH)
(72) Inventor: Graf, Markus, 8005 Zürich (CH); Streiff, Matthias, 8006 Zürich (CH); Hunziker, Werner, 8712 Stäfa (CH)
(74) Representative: Toleti, Martin

(56) References cited:
- EP-A2- 2 053 651
- US-A1- 2006 270 108
- US-A1- 2009 212 397
- US-A1- 2010 225 000

## Description

### Technical Field

The present invention relates to a sensor chip, and a method for manufacturing a sensor chip.

### Background Art

Subject to the application, sensors tend to be integrated on semiconductor substrates. This kind of manufacturing is beneficial in that the size of the sensors can significantly be reduced compared to discrete type sensors, and such sensors can be arranged next to electronic circuitry integrated on the same semiconductor substrate which circuitry may include functions acting on a signal delivered by the sensor such as amplification, evaluation, etc.

An integrated chip comprising a sensor is called sensor chip in the following. In such sensor chip, the sensor and possibly electronic circuitry are arranged at a front side of a substrate. The circuitry may be formed by CMOS processing, and the building and/or arranging of a sensing element of the sensor on the front side may be implemented in a way compatible to CMOS processing. When such sensor chip needs to be integrated into a processing system, the sensor chip typically will be connected to circuitry residing on a different circuit board, such as a printed circuit board, for example. A preferred way for mounting a sensor chip to such circuit board is a technique called flip chip mounting in which the sensor chip is flipped such that its front side containing the sensing element and the circuitry faces the circuit board and is electrically connected to it. The electrical connection typically is achieved between contact pads arranged at the front side of the sensor chip and contact pads arranged on the circuit board and solder material in between.

However, now the sensing element faces the circuit board which may not be preferred for various reasons: In case the sensor shall detect a quantity of a measure in the environment of the sensor, such measure may not have sufficient access to the sensing element for the reason of its arrangement facing the circuit board. And even if there is sufficient access granted to the medium to be measured, it may not be appreciated that such medium also gets in touch with the circuit board. In case, for example, the medium to be measured is a gas, such gas may damage the circuitry on the circuit board.

For solving the above problem, a technique called through-silicon vias may be applied. Such vias are arranged in the semiconductor substrate and represent vertical electrical connections between the front side of the substrate and its back side. A sensor chip with through-silicon vias can be mounted on the circuit board with the back side facing the circuit board and with the front side including the sensing element facing away from the circuit board. Contact pads arranged at the back side of the sensor chip allow electrically contacting the circuit board.

Through-silicon vias are manufactured by first etching holes into the substrate and filling these holes with electrically conductive material. For the reason that a high aspect ratio needs to be achieved for these holes conventional etching techniques may not be applicable. Anisotropic etching techniques such as deep reactive ion etching (DRIE) may be applied for etching holes with such high aspect ratio. On the other hand, in such etching techniques a diameter of the etched hole may strongly depend on its depth which depth may be equivalent to the thickness of the substrate. Approximately, the diameter evoked is half of the depth of the hole.

Silicon wafers which form the substrate for integrated circuits typically exhibit a thickness of several hundred micrometers µm, for example 780 µm. Given this thickness, the diameter of a hole etched through the entire substrate for building a through-silicon via is about 390 µm. On the other hand, and again subject to the application, sensing elements may only cover small areas of a semiconductor chip such that even with additional circuitry included in such chip the overall chip surface may not exceed the order of few mm². It becomes apparent that a couple of through-silicon vias would claim a major part of the surface of such a chip. As a result, the chip surface would need to be extended only because of the vias representing the largest structures on the chip. However, it is not preferred that any achievement in scaling down the sensing element and the circuitry is eaten up by the vias.

EP 2 053 651 discloses a CMOS image sensor comprising through-silicon vias formed in a thin semiconductor substrate. A packaging material surrounds the light-receiving portion of the sensor. US 2009/0212397 discloses an image sensor comprising through-substrate vias and a stiffener covering the sensing surface.

### Disclosure of the Invention

The problem to be solved by the present invention is therefore to provide a sensor chip in which the chip surface is rather determined by the size of the sensing element of the sensor and any circuitry possibly integrated therein.

This problem is solved by a sensor chip according to the features of the independent claim 1, and by a method for manufacturing a sensor chip according to the features of the independent claim 4.

The sensor chip comprises a substrate with a front side and a back side. A sensing element and conductors are arranged at the front side, and contact pads are arranged at the back side. Vias extending through the substrate between the front side and the back side are provided for electrically connecting the conductors to the contact pads. A stiffener is arranged at the front side. A thickness of the substrate is below 300 µm.

In manufacturing a sensor chip, a substrate is provided with a front side and a back side, and a sensing element is arranged at the front side as is a stiffener. Prior to etching holes for building vias extending through the substrate between the front side and the back side a thickness of the substrate is reduced to less than 300 µm by removing material from the substrate. Then, the holes are etched into the substrate, and the holes are filled with a conducting material for building the vias.

The present idea is built on the insight that prior to etching holes into the substrate, the thickness of the substrate may be reduced in order to achieve holes with a diameter smaller than the diameter of holes etched into a substrate / wafer having a standard thickness. In order to achieve diameters of holes that significantly save space on the chip surface and no longer represent elements dominating the surface size, the thickness of the substrate may need to be reduced to levels at which the substrate no longer forms a rigid element but rather is a thin flexible element. In order to compensate for the flexibility achieved as a by-product of the efforts of reducing the diameter of the through vias, a stiffener is arranged at the front side of the substrate. Such stiffener allows the entire sensor chip to form a rather rigid structure again and improves mechanical stability of the sensor chip and its handling.

Advantageous embodiments of the present idea are listed in the dependent claims as well as in the description below.

All the described embodiments shall similarly pertain to the sensor chip and the method for manufacturing a sensor chip.

Further on it shall be noted that all embodiments of the present invention concerning a method might be carried out in the order of the steps as described or in any other order unless otherwise explicitly mentioned.

### Brief Description of the Drawings

The embodiments defined above and further embodiments, features and advantages of the present invention can also be derived from the examples of embodiments to be described hereinafter in connection with the drawings in which the figures illustrate:
FIG. 1a - 1g in a longitudinal cut each, different schematic states of a sensor chip during its manufacture according to an embodiment of the present invention, and in Fig. 1g the resulting sensor chip according to an embodiment of the present invention, and
FIG. 2a - 2h in a longitudinal cut each, different schematic states of sensor chip processing on a wafer scale according to an embodiment of the present invention, and in Fig. 2h two resulting sensor chips according to an.embodiment of the present invention.

### Modes for Carrying Out the Invention

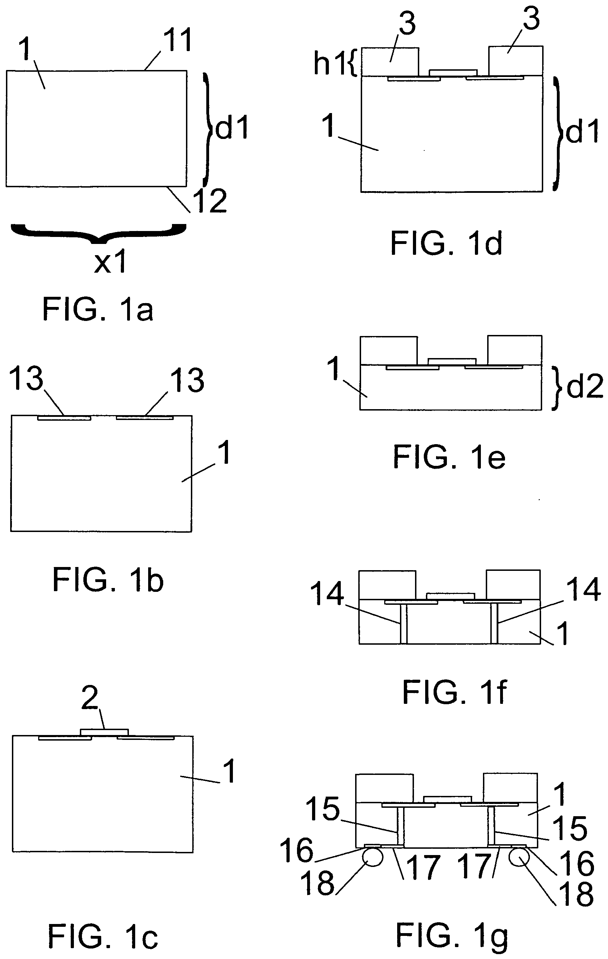

The Figures 1a to 1g schematically illustrate different states of a sensor chip, each in a longitudinal cut, during its manufacture according to an embodiment of the present invention. In Figure 1g, the resulting sensor chip is shown according to an embodiment of the present invention.

According to Figure 1a, a schematic substrate 1 is provided comprising a front side 11 and opposite to the front side 11 a back side 12. A height/depth/vertical extension/thickness of the substrate 1 is denoted by d1. In the present example, the thickness d1 of the substrate 1 is between 500 µm and 800 µm which are a common standard thicknesses of wafers. Orthogonal to the vertical extension d1 of the substrate 1, a non visible surface of the substrate 1 extends into the plane of projection, which surface, also known as chip surface, is defined by a length x1 of the substrate 1 and a non-visible width y1.

The substrate 1 advantageously is a semiconductor substrate, and preferably is a silicon substrate.

According to Figure 1b, conductors 13 are applied to the first side 11 of the substrate 1, for example, by depositing metal paths where needed. In general, the semiconductor substrate 1 is structured and processed by known processes such as CMOS processes in order to build conductors and other circuitry such as evaluation or amplification circuitry subject to the application and the scope of functionality of the sensor chip. Although there is no other passive or active circuitry shown in Figure 1b except for the conductors 13, it is understood that such circuitry may be integrated at the front side 11 of the substrate 1 where needed. In this context, when an element is to be arranged at the front side 11 of the substrate 1, such arrangement shall encompass a deposition of such element onto the surface of the substrate 1, it also shall encompass a deposition of such element onto other layers deposited on the surface of the substrate such that the element not necessarily touches the substrate 1 itself, and it shall also encompass elements/structures which are integrated into in the substrate close to the surface by means of, e.g. the above mentioned semiconductor processing, and as such are buried below other layers. Still such elements are arranged at the front side 11 in that they are not arranged at the back side or at lateral sides of the substrate 1.

In Figure 1c, a sensing element 2 supporting the measurement is deposited on the substrate 1 at its front side 11. Subject to the manufacturing process applied and the material the sensing element 2 is made of, the sensing element 2 may be deposited on or buried into the substrate 1. In both variants, the sensing element 2 may advantageously be formed by means of the same underlying processing steps as the circuitry is.

In Figure 1d, a stiffener 3 is arranged at the front side 11 of the substrate 1. Arranging the stiffener 3 at the substrate generally may include one of the following without limitation: The stiffener 3 may be an element formed separate from the substrate 1 and may be glued, bonded or otherwise mechanically connected to the substrate 1. The stiffener 3 may directly be built on the substrate 1 in form of layers deposited on the substrate 1. The stiffener 3 may be formed by moulding or casting onto the substrate 1.

As an interconnect layer for fixing the stiffener 3 to the substrate 1 one of solder, glassfrit or a polymer layer may be applied. As shown in Figure 1d, the stiffener 3 may exhibit a form surrounding the sensing element 2. The sensing element 2 is not covered by the stiffener 3 in order to allow access to the sensing element 2. The stiffener 3 has a height h1, which is preferably above 100 µm, and preferably is between 150 and 250 µm. The stiffener 3 may be provided in form of another substrate, e.g. a silicon-on-insulator, or other semiconducting layer arrangements. The stiffener 3 is made from one of a semiconductor, ceramic, glass, metal. The stiffener 3 may cover and protect at least part of circuitry, and in particular metal structures, integrated into the substrate 1, however, the stiffener 3 does not cover the sensing element 2.

In conventional CMOS processing, the building of integrated structures may be finalized by applying a dielectric layer such as an oxide, a silicon oxide or a nitride layer to the substrate 1 which shall cover any metal structures such as connectors or pads on the front side 11 of the substrate 1. In view of the stiffener 3 being applied to the front side 11 of the substrate 1 such dielectric layer may be omitted during manufacture of the sensor chip.

In the present example, the surface of the substrate 1 and consequently the surface of the resulting sensor chip may not exceed the surface of the sensitive element by far. Even with such small chip surfaces, the vias built according to embodiments of the present invention do not interfere with the small sensor chip surface due to small via diameters achievable. In the step represented by Figure 1e, the substrate 1 is thinned, e.g. by grinding, to a reduced thickness d2 less than 300 µm, preferably less than 150 µm, and in a very preferred embodiment less than 50 µm. This means, that material from the substrate 1 is removed in order to reduce the thickness d1 of the substrate 1 down to the reduced thickness d2 in order to allow etching small size/diameter holes for realizing vias, a diameter of which holes depends on the thickness of the substrate 1. For example, by using anisotropic etching such as deep reactive ion etching DRIE for building holes reaching through the substrate 1 of 150 µm thickness the diameter of such holes may in the order of 75 µm. In case the substrate 1 may be thinned to at least 50 µm, isotropic etching techniques may also be applied instead. As a result multiple holes 14 for vias DRIE for building holes reaching through the substrate 1 of 150 µm thickness the diameter of such holes may in the order of 75 µm. In case the substrate 1 may be thinned to at least 50 µm, isotropic etching techniques may also be applied instead. As a result multiple holes 14 for vias 15 can be etched into the substrate 1 by deep reactive ion etching after the substrate 1 has been thinned to the reduced thickness d2 without claiming the entire space on the chip surface. For many sensor applications, at least four through-silicon vias are formed, two for power, and two for communication.

A state of the sensor chip after etching holes 14 into the substrate 1 is shown in Figure If. The holes 14 preferably are etched into the substrate 1 from its back side 12. In a final step, the holes 14 are filled with conducting material such as Cu, polySi, Si, or others for implementing the various vias 15. In this context, a via 15 is understood as a conducting element reaching through the substrate 1. Conductors 17 provided at the back side 12 of the substrate 1 may connect the vias 15 to contact pads 16 provided elsewhere on the back side 12 of the substrate 1. In this respect, the back side 12 of the substrate 1 may be understood as a redistribution layer which allows for finally arranging solder balls 18 on the contact pads 16 with a sufficient distance from each other, such as is shown in Figure 1g. The conductors 17 of such redistribution layer may be formed on the substrate 1 at the very beginning of the process, for example after the step illustrated in Figure 1b. In another embodiment, where feasible in terms of space, some or all ends of the vias 15 at the back side 12 of the substrate 1 may form or especially be formed as contact pads 16. During etching and filling the holes 14, the sensor chip may be flipped and be seated on its stiffener 3 which protects the sensing element 2 and the other integrated structures during manufacturing. As a result, no other carrier is needed during building the through-silicon vias 15.

For the present embodiment of a manufacturing process it is advantageous that the material used for the stiffener 3 may show a high temperature stability and may be insensitive to treatments used during building the through-silicon vias 15 for the reason that the stiffener 3 may be exposed to high temperatures and such treatments during building the through-silicon vias 15.

In a preferred embodiment, the opening in the stiffener 3 granting access to the sensing element 2 may be covered by a foil or any similar element which may be provided as temporary protection during manufacturing, or, alternatively, as permanent cover provided it allows sufficient access to the sensing element. Such foil may be a polymer layer and be bonded on top of the stiffener.

The sensor chip according to Figure 1g represents a sensor chip according to an embodiment of the present invention. Such sensor chip can now be mounted to a circuit board with its back side 11 facing the circuit board. For such mounting, the sensor chip may be pressed with its solder bumps 18 against the circuit board, which in one embodiment may be a printed circuit board, in order to establish an electrical connection between the contact pads 16 of the sensor chip and contact pads of the circuit board. The solder bumps 18 may be hardened or otherwise treated such that a reliable electrical connection is established. In addition, the sensor chip may be mechanically fixed to the circuit board, for example by means of an adhesive at the back side 12 of the sensor chip, or by other means.

As a result, the front side 11 of the sensor chip, and in particular its sensing element 2, faces the environment. In such arrangement, the circuit board can be shielded from the measuring environment, for instance by means of an additional housing which may be sealed against the stiffener 3. At the same time, the sensing element 2 is sufficiently exposed to the measurement environment. There are no elements preventing access to the sensing element as are when the sensor chip would be flip chip mounted to the circuit board. Any sensor signal from the sensing element or signals derived from such sensor signal now can be transmitted to the circuitry on the circuit board via the connectors 13 and the vias 15.

As such, the vias 15 represent an electrical connection between the front side 11 of the substrate 1 and its back side 12 and in particular may help to connect conductors 13 at the front side 11 of the substrate 1 with contact pads 16 on its back side. In case the substrate 1 is embodied as a silicon substrate, the vias 15 may be named through-silicon vias.

The present order of manufacturing steps is an advantageous one in view of different aspects: In the first steps according to the Figures 1a to 1c, standard semiconductor chip manufacturing processes may be applied. As mentioned above, the stiffener 3 may be applied as protector during manufacturing of the vias 15. However, the stiffener 3 may already perform a stiffening function earlier in the process during thinning of the substrate 1. In this context, it is beneficial that the stiffener 3 is already attached to the substrate 1 prior to thinning the substrate 1 down to its reduced thickness d2 for the reason that by reducing the thickness d1 of the substrate 1 it loses its mechanical stability such that the stiffener 3 helps in regaining its mechanical stability which is also beneficial for handling the substrate 1 in subsequent process steps.

Still, except for the need of first reducing the thickness d1 of the substrate 1 and then etching the holes 14 into the substrate 1, and of arranging the stiffener 3 at the front side 11 prior to etching the holes 14, any other manufacturing steps may take a different order than listed in the claims. For example, the sensing element 2 may be attached to the substrate 1 after the stiffener 3 has been arranged at the substrate 1 provided that the technology for arranging the sensing element 2 is not prevented by the already arranged stiffener 3. Provided handling allows, the vias 15 may be built first, and the circuitry/conductors 13 and the sensing element 2 may also be formed in a later step.

In another embodiment of manufacturing a sensor chip, the circuitry and the sensitive element 2 are integrated into the substrate 1 at the very beginning according to Figures 1a to 1c. In a next step, the thickness d1 of the substrate 1 is reduced, for example by means of thinning its back side 12 according to Figure 1e, however, without the stiffener 3 already being applied.

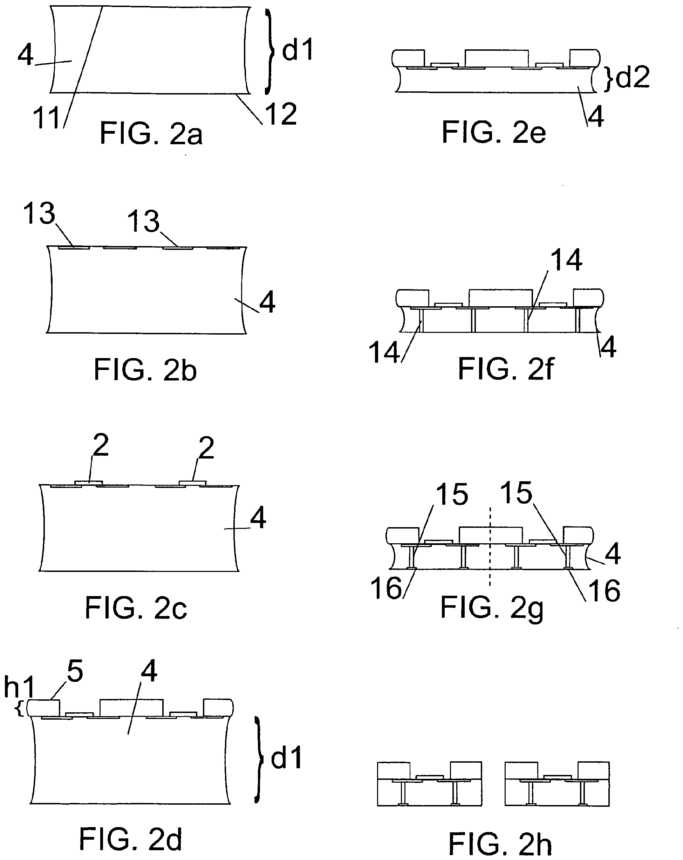

FIG. 2a - 2h schematically show different states of sensor chip processing on wafer scale, in a longitudinal cut each, according to an embodiment of the present invention. In Figure 2h, two of the resulting sensor chips are illustrated according to an embodiment of the present invention.

In Figure 2a, instead of a single substrate from which an individual sensor chip may be built, an entire wafer 4 is provided which wafer 4 constitutes a substrate for multiple sensor chips to be built from. In the present example, the sensor chips are separated from each other into individual elements at the very end of the manufacturing process, as will be explained later. During the entire processing the wafer 4 forms a common substrate for all the sensor chips to be built. Other than that, the manufacturing steps are the same as illustrated in Figure 1.

The wafer 4 is provided with a front side 11, a back side 12, and a height/depth/vertical extension/thickness d1. A length of the wafer 4, and also its width, of course, exceed the length x1 and the width y1 of the individual substrate 1 as used according to Figure 1a. Circuitry including conductors 13 and possibly other electronic components are integrated into the wafer 4 by means of CMOS processing, see Figure 2b, now for multiple sensor chips to be built. In the step illustrated in Figure 2c, an array of sensing elements 2 is formed on or in the wafer 4. Again, such sensing elements 2 can be built by the same processing steps the circuitry is built from, and, for example, such sensing elements 2 may include polymer layers receptive to humidity in the present example such that the sensor chip represents a humidity sensor for measuring a relative humidity of the environment.

The sensing elements 2 may alternatively be deposited on the wafer 4 in form of a film covering the entire wafer and be structured to finally form the individual sensing elements 2 as shown in Figure 2c.

Corresponding to the step shown in Figure 1d, the stiffeners 3 are applied to the substrate 1 subsequently. Applying/arranging the stiffeners 3 to/at the wafer 4 may include providing multiple stiffeners 3 in form of a plate 5. A shown in Figure 2d, such plate 5 may be a plate 5 of a dry resist, for example, of other suitable material where openings for accessing the sensing elements 2 are already prefabricated, or where subsequent to applying the plate 2 to the front side 11 of the wafer 4 such openings are fabricated. In this context, it may be beneficial that the entire plate 5 has a length and width equivalent to the length and width of the wafer 4. The plate 5 specifically may be made from one of silicon, silicon and a silicon-oxide coating, silicon and a solderable coating, ceramic, ceramic and a silicon-oxide coating, ceramic and a solderable coating, glass, glass and a silicon-oxide coating, glass and a solderable coating, metal, metal and a solderable coating Alternatively, applying/arranging the spacers 3 to/at the wafer 4 may include building multiple spacers 3 in form of layers deposited on the wafer 4. Alternatively, applying/arranging the spacers 3 to/at the wafer 4 may include building multiple spacers 3 by moulding or casting material onto the wafer 4.

According to Figure 2e, the entire wafer 4 is thinned to a reduced thickness of d2, i.e. preferably less than 300 µm. In the step represented by Figure 2f, from the back side 12 of the wafer 4 the holes 14 are etched for all the sensor chips, advantageously by anisotropic etching. In the step corresponding to Figure 2g, all the holes 14 are filled with conductive material in order to build vias 15 reaching through the entire reduced thickness d2 of the wafer 4 in order to connect the conductors 13 of each sensor chip to its contact pads 16 on the back side 12, which contact pads 16 in the present embodiment are arranged in a line with the associated via 15, or which may be arranged offset from the associated via 15 as shown in Figure 1g. Of course, any mix of contact pads arrangement is included without limitation.

In another embodiment, a membrane layer may be deposited on the spacer plate 5 / the spacers 3, for example by bonding, and may form part of the final spacers 3. The membrane layer 51, which may be embodied as a polymer layer, covers the openings 31, protects the sensing elements 2, is arranged distant from the sensing elements 2, and provides sufficient access for the medium to be measured.

Finally, according to Figure 2h, the sensor chips still connected via the wafer 4 and possibly the plate 5 are separated, e.g. cut into individual elements, two of which elements representing sensor chips are shown in Figure 2h. Prior to separating the individual sensor chips, solder bumps may be applied to some or all the contact pads 16 on the back side 12 of the wafer 4 in order to prepare a mounting of the individual sensor chips to their destinations such as circuit boards.

Any aspect with respect to the order of manufacturing steps explained in connection with an individual sensor chip according to Figure 1 holds for the wafer level manufacturing according to Figure 2, too. Any such variants introduced before may be introduced with respect to the wafer level manufacturing, too. In addition, after each of the manufacturing steps on the wafer level, it may be switched to subsequent manufacturing on the individual sensor chip level by cutting the wafer 4 and any other overlapping structures. However, it is preferred that at least the thinning step is applied to the entire wafer 4 instead of to individual sensor chips.

According to the invention, the sensor chip is used as one of a humidity sensor, a liquid flow sensor, a gas flow sensor, a pressure sensor, and a chemical sensor. Corresponding sensing elements are provided for each of the applications.

## Claims

1. Sensor chip, comprising
a semiconductor substrate (1) with a front side (11) and a back side (12),
a sensing element (2) and conductors (13) arranged at the front side (11), the sensing element (2) facing the environment,
contact pads (16) arranged at the back side (12),
vias (15) extending through the substrate (1) between the front side (11) and the back side (12) for electrically connecting the conductors (13) to the contact pads (16), and
a stiffener (3) arranged at the front side (11),
wherein a thickness (d2) of the substrate (1) is below 300 µm,
wherein the sensing element (2) is adapted to sense one of humidity, liquid flow, gas flow, pressure and chemicals, and
wherein the stiffener (3) extends around the sensing element (2),
wherein the stiffener (3) is made of one of a semiconductor, ceramic, metal, glass.

2. Sensor chip according to claim 1, wherein a thickness (d2) of the substrate (1) is below 150 µm, and preferably is below 50 µm.

3. Sensor chip according to any one of the preceding claims, wherein a thickness (h1) of the stiffener (3) is more than 100 µm, and preferably is between 150 and 250 µm.

4. Method for manufacturing a sensor chip, comprising the steps of
providing a semiconductor substrate (1) with a front side (11) and a back side (12),
arranging a sensing element (2) at the front side (11), wherein the sensing element (2) is adapted to sense one of humidity, liquid flow, gas flow, pressure and chemicals,
arranging a stiffener (3) at the front side (11),
reducing a thickness (d1) of the substrate (1) to less than 300 µm by removing material from the substrate (1),
etching holes (14) into the substrate (1), and
filling the holes (14) with a conducting material for building vias (15) extending through the substrate (1) between the front side (11) and the back side (12),
wherein the stiffener (3) is arranged at the front side (11) prior to etching the holes (14),
wherein the stiffener (3) extends around the sensing element (2) and the sensing element faces the environment,
wherein the stiffener (3) is made of one of a semiconductor, ceramic, metal, glass.

5. Method according to claim 4, wherein the holes (14) are etched by anisotropic etching from the backside (12) of the substrate (1).

6. Method according to claim 4 or claim 5,
wherein the substrate (1) is provided in form of a wafer (4) for building multiple sensor chips from, and
wherein sensing elements (2) and conductors for multiple sensor chips are arranged at the front side (11) of the wafer (4) prior to separating the wafer (4) into multiple individual elements.

7. Method according to claim 6, wherein multiple stiffeners (3) for multiple sensor chips are arranged at the front side (11) of the wafer (4) prior to separating the wafer (4) into multiple individual elements.

8. Method according to claim 6 or claim 7, wherein the step of reducing the thickness (d1) of the substrate (1) is applied to the complete wafer (4) prior to separating the wafer (4) into multiple individual elements.

9. Method according to any one of the preceding claims 6 to 8, wherein the step of etching holes (14) through the substrate (1) and filling the holes (14) for building vias (15) for multiple sensor chips is applied to the complete wafer (4) prior to separating the wafer (4) into multiple individual elements.

10. Method according to claim 9, wherein the holes (14) are etched into the substrate (1) from the back side (12) of the substrate (1).

## Patentansprüche

1. Sensorchip umfassend
ein Halbleitersubstrat (1) mit einer Vorderseite (11) und einer Rückseite (12),
ein Sensorelement (2) und Leiter (13), die auf der Vorderseite (11) angebracht sind, wobei das Sensorelement (2) der Umgebung zugewandt ist,
Kontaktpads (16), die auf der Rückseite (12) angebracht sind,
Durchkontaktierungen (15), die sich durch das Substrat (1) zwischen der Vorderseite (11) und der Rückseite (12) erstrecken, um die Leiter (13) mit den Kontaktpads (16) elektrisch zu verbinden, und
eine auf der Vorderseite (11) angebrachte Versteifung (3),
wobei eine Dicke (d2) des Substrats (1) unter 300 µm liegt,
wobei das Sensorelement (2) geeignet ist, entweder Feuchtigkeit, Flüssigkeitsdurchfluss, Gasdurchfluss, Druck oder Chemikalien zu erfassen, und
wobei sich die Versteifung (3) um das Sensorelement (2) herum erstreckt,
wobei die Versteifung (3) aus einem von einem Halbleiter, einer Keramik, einem Metall oder einem Glas hergestellt ist.

2. Sensorchip nach Anspruch 1, wobei eine Dicke (d2) des Substrats (1) unter 150 µm, und vorzugsweise unter 50 µm, liegt.

3. Sensorchip nach einem der vorhergehenden Ansprüche, wobei eine Dicke (h1) der Versteifung (3) mehr als 100 µm, und vorzugsweise zwischen 150 und 250 µm, beträgt.

4. Verfahren zur Herstellung eines Sensorchips umfassend die folgenden Schritte
Bereitstellen eines Halbleitersubstrats (1) mit einer Vorderseite (11) und einer Rückseite (12),
Anbringen eines Sensorelements (2) auf der Vorderseite (11), wobei das Sensorelement (2) geeignet ist, entweder Feuchtigkeit, Flüssigkeitsdurchfluss, Gasdurchfluss, Druck oder Chemikalien zu erfassen,
Anbringen einer Versteifung (3) auf der Vorderseite (11),
Verringern einer Dicke (d1) des Substrats (1) auf weniger als 300 µm durch Entfernen von Material vom Substrat (1),
Ätzen von Löchern (14) in das Substrat (1), und Füllen der Löcher (14) mit einem leitenden Material zum Erstellen von Durchkontaktierungen (15), die sich durch das Substrat (1) zwischen der Vorderseite (11) und der Rückseite (12) erstrecken,
wobei die Versteifung (3) vor dem Ätzen der Löcher (14) auf der Vorderseite (11) angebracht wird,
wobei sich die Versteifung (3) um das Sensorelement (2) herum erstreckt und das Sensorelement der Umgebung zugewandt ist,
wobei die Versteifung (3) aus einem von einem Halbleiter, einer Keramik, einem Metall oder einem Glas hergestellt ist.

5. Verfahren nach Anspruch 4, wobei die Löcher (14) durch anisotropes Ätzen von der Rückseite (12) des Substrats (1) aus geätzt werden.

6. Verfahren nach Anspruch 4 oder Anspruch 5,
wobei das Substrat (1) in Form eines Wafers (4) zum Herstellen mehrerer Sensorchips bereitgestellt wird, und
wobei Sensorelemente (2) und Leiter für mehrere Sensorchips auf der Vorderseite (11) des Wafers (4) angebracht werden, bevor der Wafer (4) in mehrere Einzelelemente zerteilt wird.

7. Verfahren nach Anspruch 6, wobei mehrere Versteifungen (3) für mehrere Sensorchips auf der Vorderseite (11) des Wafers (4) angebracht werden, bevor der Wafer (4) in mehrere Einzelelemente zerteilt wird.

8. Verfahren nach Anspruch 6 oder Anspruch 7, wobei der Schritt des Verringerns der Dicke (d1) des Substrats (1) vor dem Zerteilen des Wafers (4) in mehrere Einzelelemente auf den gesamten Wafer (4) angewendet wird.

9. Verfahren nach einem der vorhergehenden Ansprüche 6 bis 8, wobei der Schritt des Ätzens von Löchern (14) durch das Substrat (1) und des Füllens der Löcher (14) zum Erstellen von Durchkontaktierungen (15) für mehrere Sensorchips auf den gesamten Wafer (4) angewendet wird, bevor der Wafer (4) in mehrere Einzelelemente zerteilt wird.

10. Verfahren nach Anspruch 9, wobei die Löcher (14) von der Rückseite (12) des Substrats (1) in das Substrat (1) geätzt werden.

## Revendications

1. Puce de capteur comprenant
un substrat semi-conducteur (1) ayant une face avant (11) et une face arrière (12),
un élément capteur (2) et des conducteurs (13) agencés sur la face avant (11), l'élément capteur (2) étant orienté vers l'environnement,
des plages de contact (16) agencés sur la face arrière (12),
des trous d'interconnexion (15) s'étendant à travers le substrat (1) entre la face avant (11) et la face arrière (12) pour connecter électriquement les conducteurs (13) aux plages de contact (16), et
un raidisseur (3) agencé sur la face avant (11),
dans laquelle une épaisseur (d2) du substrat (1) est inférieure à 300 µm,
dans laquelle l'élément capteur (2) est adapté pour détecter soit l'humidité, soit le débit de liquide, soit le débit de gaz, soit la pression, soit les produits chimiques, et
dans laquelle le raidisseur (3) s'étend autour de l'élément capteur (2),
dans laquelle le raidisseur (3) est constitué d'un semi-conducteur, d'une céramique, d'un métal ou d'un verre.

2. Puce de capteur selon la revendication 1, dans laquelle une épaisseur (d2) du substrat (1) est inférieure à 150 µm, et de préférence inférieure à 50 µm.

3. Puce de capteur selon l'une des revendications précédentes, dans laquelle une épaisseur (h1) du raidisseur (3) est supérieure à 100 µm, et de préférence comprise entre 150 et 250 µm.

4. Procédé de fabrication d'une puce de capteur comprenant les étapes suivantes
fournir un substrat semi-conducteur (1) ayant une face avant (11) et une face arrière (12),
agencer un élément capteur (2) sur la face avant (11), l'élément capteur (2) étant adapté pour détecter soit l'humidité, soit le débit de liquide, soit le débit de gaz, soit la pression, soit les produits chimiques,
agencer un raidisseur (3) sur la face avant (11),
réduire une épaisseur (d1) du substrat (1) à moins de 300 µm en enlevant de la matière du substrat (1) ,
graver des trous (14) dans le substrat (1), et
remplir les trous (14) avec un matériau conducteur pour former des trous d'interconnexion (15) traversant le substrat (1) entre la face avant (11) et la face arrière (12),
dans lequel le raidisseur (3) est agencé sur la face avant (11) avant de graver les trous (14),
dans lequel le raidisseur (3) s'étend autour de l'élément capteur (2) et l'élément capteur fait face à l'environnement,
dans lequel le raidisseur (3) est constitué d'un semi-conducteur, d'une céramique, d'un métal ou d'un verre.

5. Procédé selon la revendication 4, dans lequel les trous (14) sont gravés par gravure anisotrope à partir de la face arrière (12) du substrat (1).

6. Procédé selon la revendication 4 ou la revendication 5,
dans lequel le substrat (1) est fourni sous la forme d'une plaquette (4) pour produire une pluralité de puces de détection, et
dans lequel des éléments de détection (2) et des conducteurs pour plusieurs puces de détection sont agencés sur la face avant (11) de la plaquette (4) avant que celle-ci ne soit divisée en plusieurs éléments individuels.

7. Procédé selon la revendication 6, dans lequel plusieurs raidisseurs (3) pour plusieurs puces de détection sont agencés sur la face avant (11) de la plaquette (4) avant que la plaquette (4) ne soit divisée en plusieurs éléments individuels.

8. Procédé selon la revendication 6 ou la revendication 7, dans lequel l'étape de réduction de l'épaisseur (d1) du substrat (1) est appliquée à la plaquette entière (4) avant que la plaquette (4) ne soit divisée en une pluralité d'éléments individuels.

9. Procédé selon l'une des revendications 6 à 8 précédentes, dans lequel l'étape consistant à graver des trous (14) à travers le substrat (1) et à remplir les trous (14) pour réaliser des trous d'interconnexion (15) pour une pluralité de puces de détection est appliquée à la plaquette entière (4) avant que la plaquette (4) ne soit divisée en une pluralité d'éléments individuels.

10. Procédé selon la revendication 9, dans lequel les trous (14) sont gravés dans le substrat (1) à partir de la face arrière (12) du substrat (1).
